# EUROPÄISCHE PATENTSCHRIFT

(11) **EP 3 516 413 B1**
(45) Veröffentlichungstag und Bekanntmachung des Hinweises auf die Patenterteilung: **26.05.2021**
(21) Anmeldenummer: 17755530.7
(22) Anmeldetag: 24.08.2017
(51) Int. Cl.: G01S 7/35, G01S 13/34, H01Q 23/00

(54) **FREQUENZWANDLER-SCHALTUNG FÜR EIN RADAR-BASIERTES MESSGERÄT**
FREQUENCY CONVERTER CIRCUIT FOR A RADAR BASED MEASUREMENT DEVICE
CIRCUIT DE CONVERTISSEUR DE FRÉQUENCE POUR UN DISPOSITIF BASÉ SUR RADAR

(30) Priorität: 22.09.2016 DE 102016117920
(43) Veröffentlichungstag der Anmeldung: 31.07.2019
(73) Patentinhaber: Endress+Hauser SE+Co. KG, 79689 Maulburg (DE)
(72) Erfinder: BLÖDT, Thomas, 79585 Steinen (DE); KLÖFER, Peter, 79585 Steinen (DE)
(74) Vertreter: Andres, Angelika Maria
(86) Internationale Anmeldenummer: PCT/EP2017/071351
(87) Internationale Veröffentlichungsnummer: WO 2018/054649

(56) Entgegenhaltungen:
- WO-A2-00/45460
- WO-A2-01/27861
- JP-A- 2003 194 918

## Beschreibung

Die Erfindung betrifft eine Frequenzwandler-Schaltung für ein Radar-basiertes Messgerät, welches zur Bestimmung des Abstandes zu einem Messobjekt oder zur Bestimmung von dessen Geschwindigkeit dient.

Radar-basierte Distanz- und Geschwindigkeitsmessung wird in einem breiten Anwendungsspektrum genutzt, beispielsweise zur Positionsbestimmung in der Luftfahrt, zur Abstands- bzw. Geschwindigkeitsmessung bei Kraftfahrzeugen oder auch zur Füllstandsbestimmung in der Prozessautomation.

Hierzu können prinzipiell zwei unterschiedliche Radar-Technologien nach dem Stand der Technik eingesetzt werden: Zum einen FMCW ("Frequency Modulated Continuos Wave", auch bekannt als Dauerstrichradar) oder das sogenannte Puls-Laufzeit-Verfahren. Beide Verfahren werden innerhalb von vordefinierten Radar-Frequenzbändern betrieben (im Rahmen dieser Patentanmeldung werden elektromagnetische Wellen mit Frequenzen zwischen 0.3 GHz und 300 GHz als Radar-Wellen betrachtet).

Im Falle von Radar-basierter Füllstandsmessung wird in Radar-Frequenzbändern bei 6 GHz, 26 GHz oder 79 GHz gearbeitet. Dabei sind die höherliegenden Frequenzbänder bevorzugt, da in diesen Fällen eine größere absolute Bandbreite genutzt werden kann. Dies ermöglicht wiederum eine höhere Mess-Genauigkeit. Insbesondere bei der Füllstandsmessung stellt dies eine wichtige Anforderung dar, denn hier ist speziell bei großen Behältern eine möglichst genaue Kenntnis des Füllstandes (L) gefragt. Ein weiterer Vorteil bei der Verwendung hoher Frequenzen besteht darin, dass kleinere Antennen (und somit auch kleinere Anschluss-Flansche zur Anbringung am Behälter) verwendet werden können, ohne dass die Bündelungs-Wirkung der Antenne vermindert wird.
Daher ist es erstrebenswert, Füllstandsmessung oder Distanz- bzw. Geschwindigkeitsmessung im Allgemeinen bei höheren Frequenzen als 79 GHz (bis hin zu sehr hohen Radarfrequenzen bis zu 300 GHz) zu betreiben. Oberhalb von 60 GHz ist es jedoch zunehmend schwierig, die hochfrequenten Sende- und Empfangssignale innerhalb des Messgerätes signaltechnisch zu verarbeiten. Der Grund hierfür liegt in der erhöhten Störempfindlichkeit sowie der steigenden Absorption der Signale.

Ein Ansatz zur Erzeugung sehr hochfrequenter Radar-Sendesignale (Txₕ) für Anwendungen in der Füllstandsmessung wird in der Offenlegungsschrift DE 10 2001 078 060 A1 beschrieben: Die dort gezeigte Sende-Schaltung ist auf einer Leiterplatte angeordnet und basiert auf einem Hochfrequenz-Transistor. Dabei wird der Hochfrequenz-Transistor durch einen Oszillator, beispielsweise einen Quarzoszillator bei einer niedrigen Frequenz im ein- oder zweistelligen GHz-Bereich angeregt. Durch entsprechende Verschaltung des Transistors wird an dessen Ausgang ein hochfrequentes elektrisches Oberwellen-Signal erzeugt, wobei die Oberwellen-Frequenz einem ganzzahligen Vielfachen der niederfrequenten Oszillator-Frequenz entspricht. Das vom Transistor erzeugte hochfrequente Oberwellen-Signal kann darauffolgend über eine Sendeantenne ausgekoppelt werden, so dass ein hochfrequentes Radar-Sendesignal (Txₕ) abgestrahlt wird. Dadurch bietet die in der DE 10 2001 078 060 A1 beschriebene Schaltung den Vorteil, dass das hochfrequente Sendesignal (Txₕ) ohne weitere Verarbeitung auf der Leiterplatte und somit sehr verlustarm über die Sendeantenne abgestrahlt werden kann.

Das hochfrequente Sendesignal (Txₕ) wird in der Folge an dem Messobjekt, dessen Abstand (d) zum Messgerät oder dessen Geschwindigkeit zu bestimmen ist, reflektiert und als hochfrequentes Empfangssignal (Rxₕ) vom Messgerät empfangen. Dabei entspricht die Frequenz des Empfangssignals (Rxₕ) der Frequenz des hochfrequenten Sendesignals (Txₕ).

Im Gegensatz zum Sendesignal (Txₕ) muss das Empfangssignal (Rxₕ) bei dem in DE 10 2001 078 060 A1 offenbarten Ansatz jedoch mit der vorliegenden, hohen Frequenz verarbeitet werden. Hierdurch wird die höchstmögliche Frequenz des Empfangssignals (Rxₕ), und somit auch der Frequenz des Sendesignals (Txₕ), in der Praxis auf Werte bis ca. 60 GHz (und unter Inkaufnahme diverser Nachteile, wie verringerte Messgenauigkeit und Beschränkung auf stark reflektierende Füllgut-Oberflächen bis 100 GHz) beschränkt.

In der japanischen Veröffentlichungsschrift JP 2003 194918 A ist eine Frequenzwandler-Schaltung für Radar-basierte Messgeräte beschrieben, das zur Frequenzwandlung als nichtlineares elektrisches Bauteil eine Diode umfasst.

Die internationale Veröffentlichungsschrift WO 01/27861 A2 beschreibt eine Sende-/Empfangsschaltung für Radargeräte, bei der eine Frequenzwandler-Schaltung implementiert ist. Dabei dient zur Frequenzwandlung ein harmonischer Oberwellenoszillator.

In der internationalen Veröffentlichungsschrift WO00/45460 A2 wird ebenfalls eine Sende-/Empfangsschaltung für Radargeräte beschrieben, bei der eine Frequenzwandler-Schaltung implementiert ist. In diesem Fall ist zur Frequenzwandlung ein GaAs-basierter FET-Transistor implementiert.

Der Erfindung liegt die Aufgabe zugrunde, ein Radar-basiertes Distanz- bzw. Geschwindigkeits-Messgerät zu ermöglichen, welches mit sehr hohen Radar-Frequenzen arbeiten kann, und welche das Radar-Signal effizient ein- bzw. auskoppelt.

Die Erfindung löst diese Aufgabe durch eine Frequenzwandler-Schaltung gemäß Anspruch 1. Sie umfasst u.a.:
- Ein nichtlineares Hochfrequenz-Bauteil mit
   ∘ einem Frequenz-Anschluss, und
   ∘ einem Signal-Anschluss, welcher als Signaleingang für ein niederfrequentes Eingangssignal (Txₗ) im Frequenzbereich unterhalb von 60 GHz dient,
   - zumindest eine am Signal-Anschluss angeschlossene erste Sendeantenne zur
   Erzeugung eines hochfrequenten Sendesignals (Txₕ) z.B. von bis zu mehr als 300 GHz,
   - einen Schwingkreis, der am Frequenz-Anschluss angeschlossen ist,
   - zumindest eine erste Empfangsantenne zum Empfang eines hochfrequenten Empfangssignals (Rxₕ), wobei die Empfangsantenne an einem Signalausgang für ein niederfrequentes Auswertesignal (Rxₗ) angeschlossen ist,
   - zumindest ein erstes nichtlineares Halbleiterbauelement zum Runtermischen des hochfrequenten Empfangssignals (Rxₕ), wobei das Halbleiterbauelement zwischen der ersten Empfangsantenne und einer Signalmasse angeordnet ist. Im einfachsten Fall kann hierfür wiederum eine (Hochfrequenz-) Diode oder ein Verstärker eingesetzt werden.

Zusätzlich ist eine (galvanisch von den restlichen Komponenten getrennte) Antennenanordnung vorgesehen, die das hochfrequente Sendesignal (Txₕ) in Richtung des Messobjektes auskoppelt, und/oder die das vom Messobjekt reflektierte hochfrequente Empfangssignal (Rxₕ) zumindest in die erste Empfangsantenne einkoppelt. Bezüglich des niederfrequenten Eingangssignals (Txₗ) ist es vorteilhaft, wenn der Schwingkreis auf die Frequenz am Signaleingang abgestimmt ist.

Die erfindungsgemäße Frequenzwandler-Schaltung nutzt somit den Effekt, dass durch das niederfrequente Eingangssignal (Txₗ) entsprechende Oberwellen am nicht-linearen Hochfrequenz-Bauteil angeregt werden. Hieraus ergibt sich der Vorteil, dass einerseits ein sehr hochfrequentes Radar-Sendesignal (Txₕ) erzeugt und effizient ausgekoppelt werden kann, wobei das verwendete Trägersubstrat des Schaltkreises (beispielsweise die Leiterplatte) hierfür nicht hochfrequenztauglich sein muss. Dabei kann beispielsweise bei einem niederfrequenten Eingangssignal (Txₗ) im Bereich von 5 GHz bis 50 GHz und einem Frequenzmultiplikationsfaktor zwischen 3 und 12 (dieser wird über das nichtlineare Hochfrequenz-Bauteil und den Schwingkreis eingestellt) eine Frequenz des hochfrequenten Sendesignals (Txₕ) im Bereich von bis zu 300 GHz oder mehr erreicht werden.

Neben der Erzeugung des hochfrequenten Sendesignals (Txₕ) wird zudem das hochfrequente Empfangssignal (Rxₕ) in niederfrequentes Auswertesignal (Rxₗ) runtergemischt. Hierdurch wird ermöglicht, dass die weitere Ermittlung des Abstandes (d) auf Basis des einfacher verarbeitbaren, niederfrequenten Auswertesignals (Rxₗ) geschehen kann. Dabei kann die erfindungsgemäße Frequenzwandler-Schaltung sowohl beim Puls-Laufzeit-Verfahren als auch beim FMCW-Verfahren eingesetzt werden, so dass bei beiden Verfahren die jeweiligen Vorteile hoher Radar-Frequenzen genutzt werden können.

Erfindungsgemäß handelt es sich bei dem nicht-linearen Hochfrequenz-Bauteil um einen bipolar- oder FET-Transistor mit
- einem Basis- bzw. Gate-Anschluss,
- einem als Signal-Anschluss dienenden Kollektor-Anschluss bzw. Source-Anschluss, und
- einem als Frequenz-Anschluss dienenden Emitter- bzw. Drain-Anschluss handelt. Aufgrund der schnellen Umschaltcharakteristik bietet es sich an, wenn der Transistor als Hochfrequenz-Transistor ausgelegt ist.

Damit der Basis- bzw. Gate-Anschluss nicht unkontaktiert ist und dadurch HF-technisch störende Reflexionen vermieden werden, ist es von Vorteil, wenn dieser Anschluss an eine Spannungsquelle angeschlossen ist. In diesem Fall ist es von besonderem Vorteil, wenn diese Spannungsquelle den Gate-Anschluss derart mit einer Versorgungsspannung (V_{bias}) versorgt, dass der Transistor im Sättigungsbereich arbeitet.

Erfindungsgemäß umfasst die Frequenzwandler-Schaltung zusätzlich:
- Eine am Basis- bzw. Gate-Anschluss angeschlossene zweite Sendeantenne zur zusätzlichen Erzeugung des hochfrequenten Sendesignals (Txₕ),
- eine zweite Empfangsantenne zum zusätzlichen Empfang des hochfrequenten Empfangssignals (Rxₕ), wobei die zweite Empfangsantenne an dem Signalausgang angeschlossen ist,
- ein zweites nichtlineares Halbleiterbauelement, welches zwischen der zweiten Empfangsantenne und der Signalmasse angeordnet ist.

Hierdurch wird der Effekt genutzt, dass die entsprechenden Oberwellen zum Senden nicht nur am Kollektor- bzw. Source-Anschluss abgegriffen werden können, sondern auch am Basis- bzw. Gate-Anschluss durch die zweite Sendeantenne. Die zweite Empfangsantenne dient in diesem Fall dazu, ein symmetrisches Verhältnis zwischen Empfangs- und Sendeantennen herzustellen. Bei dieser Ausgestaltungsvariante können somit das hochfrequente Sendesignal (Txₕ) sowie das hochfrequente Empfangssignal (Rxₕ) effizienter aus- bzw. eingekoppelt werden.

Ein zentraler Vorteil der erfindungsgemäßen Frequenzwandler-Schaltung besteht darin, dass sie auf einer nicht Hochfrequenztauglichen Leiterplatte angeordnet werden kann und trotzdem keine aufwendige Hohlleiter-Technologie erfordert. Insbesondere die Sende- und Empfangsantennen können bei Anordnung der Schaltung auf einer Leiterplatte sehr einfach umgesetzt werden. So können/kann die erste Sendeantenne und/oder zumindest die erste Empfangsantenne als Mäander-, Spiral- oder Fraktal-Antennen, oder insbesondere als Patch-Antennen ausgelegt werden.

Die zweite Sendeantenne kann derart ausgelegt werden, dass sie einen im Vergleich zur ersten Sendeantenne verschiedenen Sende-Wirkungsgrad aufweist. Hierdurch kann der Effekt kompensiert werden, dass das Sendesignal (Txₕ) am Source-Anschluss und am Gate-Anschluss gegebenenfalls jeweils mit unterschiedlicher mit unterschiedlicher Leistung anliegt. Dies würde bei gleichem Sendewirkungsgrad der zwei Sendeantennen zu einem unsymmetrischen Abstrahlen des Radar-Sendesignals (Txₕ), also einem "Schielen" der Antennenanordnung führen.

Neben den Sende- und Empfangsantennen kann auch der Schwingkreis als Leiterbahn realisiert werden, sofern die Frequenzwandler-Schaltung auf Leiterplattenbasis aufgebaut ist: So kann der als Leiterbahn ausgestaltete Schwingkreis beispielsweise geradlinig ausgeführt werden und zumindest in einem, oder insbesondere in beiden Endbereichen mit einem Durchkontaktierungsloch verbunden sein. Somit werden separate Kondensatoren und/oder Spulen mit gegebenenfalls sehr beschränkter Grenzfrequenz vermieden.

Die Antennenanordnung, die zusätzlich zu den Sende- und Empfangsantennen vorhanden ist, hat die Funktion, das hochfrequente Sendesignal (Txₕ) gerichtet in Richtung des Messobjektes auszukoppeln und gleichzeitig das hochfrequente Empfangssignal (Rxₕ) effizient einzukoppeln, ohne dass zusätzlich eine Sende-/Empfangsweiche (oder alternativ jeweils eine separate Sende- und Empfangsantenne) erforderlich ist. Um dies optimal umzusetzen, ist diese Antennenanordnung daher vorzugsweise so zu realisieren, dass sie das hochfrequente Sendesignal (Txₕ), welches zumindest von der ersten Sendeantenne ausgestrahlt wird, zumindest teilweise in eine andere Mode, insbesondere die TE11 Mode der Antennenanordnung, umwandelt. Dementsprechend ist die Antennenanordnung des Weiteren so auszugestalten, dass sie das hochfrequente Empfangssignal (Rxₕ), welches von dem Messobjekt reflektiert wird, zumindest teilweise wiederum in eine andere Mode, insbesondere die TE22 Mode der Antennenanordnung, umwandelt.

Die Antennenanordnung kann beispielsweise in Form einer modifizierten Hornantenne aufgebaut sein. Im Fall einer Hornantenne könnte die oben beschriebene Modenwandlung erreicht werden, indem die Hornantenne in einer Sektion eine Diskontinuität des sich vergrößernden Durchmessers, beispielsweise eine entsprechende Einschnürung oder Aufweitung, aufweist. Die Ausrichtung der Hornantenne wäre in diesem Fall in etwa senkrecht zur Oberfläche der Leiterplatte, wobei sie vorzugsweise galvanisch von der Leiterplatte getrennt ist. Alternativ könnte die zusätzliche Antennenanordnung auch durch zwei separate Einzelantennen realisiert werden, wobei in diesem Fall jeweils eine zum Senden bzw. zum Empfangen dient.

Eine ergänzende Weiterentwicklung der erfindungsgemäßen Frequenzwandler-Schaltung sieht vor, dass die erste Empfangsantenne eine als Leiterbahn ausgestaltete erste Hochfrequenz-Koppelstruktur, die an den Source-Anschluss ankoppelt, aufweist. Für den Fall, dass die Frequenzwandler-Schaltung eine zweite Empfangsantenne umfasst, kann auch die zweite Empfangsantenne eine als Leiterbahn ausgestaltete zweite Hochfrequenz-Koppelstruktur aufweisen, welche an den Gate-Anschluss ankoppelt. Die Ausrichtung der Koppelstrukturen ist dabei vorzugsweise parallel zu denjenigen Leiterbahnen, die zum Basis oder Gate-Anschluss bzw. dem Kollektor- oder Source-Anschluss führen.

Durch entsprechende Ausgestaltung dieser Koppelstrukturen kann eine zusätzliche, individuelle Verstärkung des niederfrequenten Empfangssignals (Rxₗ) eingeprägt werden. Alternativ zu einer Verschaltung der Empfangsantenne(n) mittels einem als Diode ausgestalteten, nichtlinearen Halbleiterbauelement sowie der Koppelstruktur könnte deren Funktion alternativ auch durch einen entsprechend verschalteten Verstärker erreicht werden. In diesem Fall könnte der Verstärker kostengünstig auf die Frequenz des niederfrequenten Empfangssignals (Rxₗ) ausgelegt werden, wobei wiederum das nichtlineare Übertragungsverhalten des Verstärkers das Heruntermischen des hochfrequenten Empfangssignals (Rxₕ) bewirkt.

Neben dem Einsatz in Automotive- oder Luftfahrt-Applikationen bietet sich die erfindungsgemäße Frequenzwandler-Schaltung vor allem zur Verwendung in Radarbasierten Füllstandsmessgeräten an, da diese Dank hohen Radar-Frequenzen eine verbesserte Messgenauigkeit und kleinere Antennen-Antennen-Geometrien (und dadurch insgesamt kleinere Abmessungen des Füllstandsmessgerätes) realisiert werden können. Dementsprechen handelt es sich im Fall von Füllstandsmessung bei dem Messobjekt um eine Oberfläche eines Füllgutes in einem Behälter, wobei mittels des Abstandes (d) zwischen Füllstandsmessgerät und der Oberfläche der Füllstand (L) des Füllgutes in dem Behälter ermittelt wird.

Anhand der nachfolgenden Figuren wird die Erfindung näher erläutert. Es zeigt:
Fig. 1: Ein Ersatzschaltbild der erfindungsgemäßen Frequenzwandler-Schalung,
Fig. 2: eine Anordnung der Frequenzwandler-Schaltung auf einer Leiterplatte,
Fig. 3: eine vorteilhafte Ausgestaltung der Antennenanordnung der Frequenzwandler-Schaltung, und
Fig. 4: : eine Verwendung der Frequenzwandler-Schaltung in einem Füllstandsmessgerät.

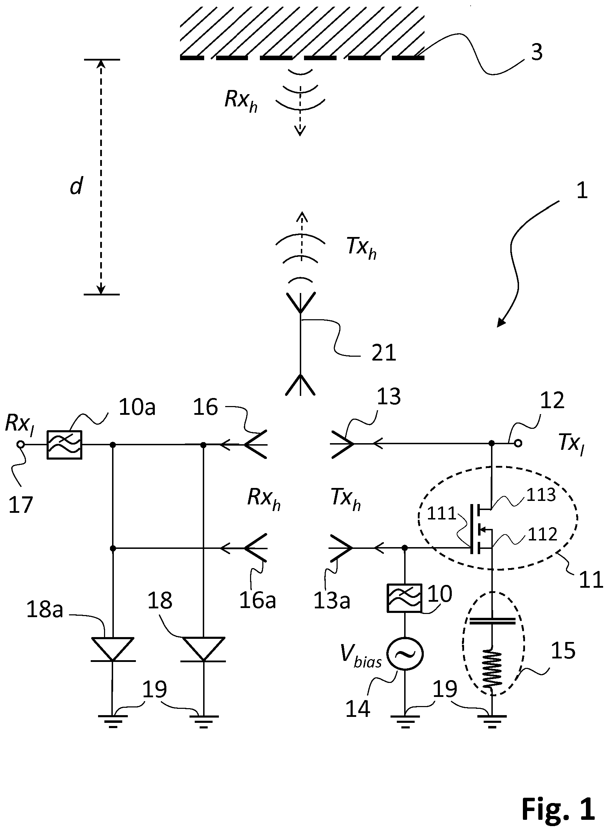

In Fig. 1 ist ein elektrisches Ersatzschaltbild einer bevorzugten Ausführungsvariante der erfindungsgemäßen Frequenzwandler-Schaltung 1 dargestellt. Kern der Frequenzwandler-Schaltung 1 ist ein als FET Transistor 11 ausgelegtes nichtlineares Hochfrequenz-Bauteil mit einem Source-Anschluss 113, einem Drain-Anschluss 112 und einem Gate-Anschluss 111. Der Source-Anschluss 113 ist an einen Signaleingang 12 angeschlossen. Über den Signaleingang 12 wird dem Transistor 11 ein niederfrequentes Eingangssignal Txₗ eingeprägt. Mittels einer Spannungsquelle 14 wird am Gate-Anschluss 111 eine Versorgungsspannung V_{bias} eingeprägt. Sie ist so ausgelegt, dass der Transistor 11 im Sättigungsbereich arbeitet. Um zu verhindern, dass hochfrequente Signale in die Spannungsquelle 14 zurückkoppelt werden, ist zwischen der Spannungsquelle 14 und dem Gate-Anschluss 111 ein entsprechend ausgelegter erster Tiefpassfilter 10 angeordnet. Am Drain-Anschluss 112 ist ein LC-Schwingkreis 15 angeschlossen, der auf die Frequenz am Signaleingang 12 abgestimmt ist.

Durch die Beschaltung des Transistors 11 wirkt dieser als Oberwellen-Oszillator. Dabei können die Grund- und Oberfrequenzen sowohl am Source-Anschluss 113, als auch am Gate-Anschluss 111 abgegriffen werden. In der gezeigten Ausführungsvariante ist daher sowohl am Source-Anschluss 113 als auch am Gate-Anschluss 111 jeweils eine Sendeantenne 13, 13a angeschlossen. Dabei sind die zwei Sendeantennen 13, 13a so ausgelegt, dass sie die niedrige Grundfrequenz unterdrücken, während die gewünschten Oberwellenfrequenzen mit hohem Sende-Wirkungsgrad abstrahlen. Somit wird durch die zwei Sendeantennen 13, 13a ein hochfrequentes Radar-Sendesignal Txₕ auf Basis der Oberwellen erzeugt und abgestrahlt.

Um den Abstand d zu einem Messobjekt 3 bestimmen zu können, oder zur Bestimmung von dessen Geschwindigkeit, ist das Sendesignal Txₕ gerichtet zum Messobjekt hin 3 auszukoppeln. Dies geschieht über eine zusätzliche Antennenanordnung 21.

Dadurch bedingt, dass durch das Eingangssignal Txₗ eine Spannung am Signaleingang 12 anliegt, wird die Frequenzwandler-Schaltung 1 mit Energie versorgt. Dies kann bei entsprechender Auslegung des Eingangssignals Txₗ, beispielsweise als gepulstes Sinus-Signal, genutzt werden, um den Transistor 11 getaktet zu betreiben und somit ein getaktetes Sendesignal Txₕ zu erzeugen, wie es insbesondere beim Puls-Laufzeit Radar-Messverfahren benötigt wird.

Um die erfindungsgemäße Frequenzwandler-Schaltung 1 im FMCW-Modus zu betreiben, ist es hingegen vorteilhaft, ein kontinuierliches sinusförmiges niederfrequentes Eingangssignal Txₗ einzuprägen, welches eine Frequenzrampe (auch bekannt als Frequenzhub) aufweist. In diesem Fall ist die Frequenzrampe des Eingangssignals Txₗ vorzugsweise so zu wählen, dass dessen Maximalfrequenz höher (insbesondere doppelt so hoch) wie die Bandbreite des resultierenden hochfrequenten Sendesignals Txₕ ist.

Auch das Empfangssignal Rxₕ, das durch Reflektion des Sendesignals Txₕ an der Oberfläche des Messobjekts 3 entsteht, wird über die Antennenanordnung 21 empfangen. Die anschließende Einkopplung des Empfangssignals Rxₕ in die Frequenzwandler-Schaltung 1 erfolgt über zwei Empfangsantennen 16, 16a.

Erfindungsgemäß wird das hochfrequente Empfangssignal Txₕ wieder heruntergemischt und somit in ein niederfrequentes Auswertesignal Rxₗ erhalten. Hierzu ist jede der zwei Empfangsantennen 16, 16a über jeweils eine Hochfrequenz-Diode 18, 18a mit Signalmasse 19 verbunden. Das Heruntermischen des hochfrequenten Empfangssignals Rxₕ wird hierbei durch die nichtlineare Kennlinie der Hochfrequenz-Dioden 18, 18a bewirkt.

Da sich die Funktion des Heruntermischens aus dem nichtlinearen Verhalten ergibt, könnte anstelle der Dioden 18, 18a alternativ auch jegliches andere elektrische Bauelement mit entsprechend nichtlinearer IV-Kennlinie eingesetzt werden. Das so erhaltene, niederfrequente Auswertesignal Rxₗ wird zur Weiterverarbeitung bereitgestellt, indem die zwei Empfangsantennen 16, 16a mit einem Signalausgang 17 kontaktiert sind. Zur Unterdrückung des hochfrequenten Empfangssignals Rxₕ am Signalausgang ist diesem ein entsprechend ausgelegter Tiefpassfilter 10a vorgeschaltet. Alternativ zum Tiefpassfilter 10a könnte auch ein Bandpassfilter, dessen Durchlassfrequenz auf das niederfrequente Auswertesignal Rxₗ abgestimmt ist, verwendet werden.

Durch die Ausführungsvariante, die in Fig. 1 dargestellt ist, ergibt sich somit der erfindungsgemäße Vorteil, dass einerseits ein sehr hochfrequentes Radar-Sendesignal Txₕ erzeugt und effizient ausgekoppelt werden kann. Darüber hinaus wird aber auch das hochfrequente Empfangssignal Rxₕ wieder in niederfrequentes Auswertesignal Rxₗ runtergemischt, wodurch die weitere Ermittlung des Abstandes d auf Basis des einfacher handhabbaren, niederfrequenten Auswertesignals Rxₗ geschehen kann und das hochfrequente Empfangssignal Rxₕ nicht über weite und somit verlustreiche Leitungswege transportiert werden muss.

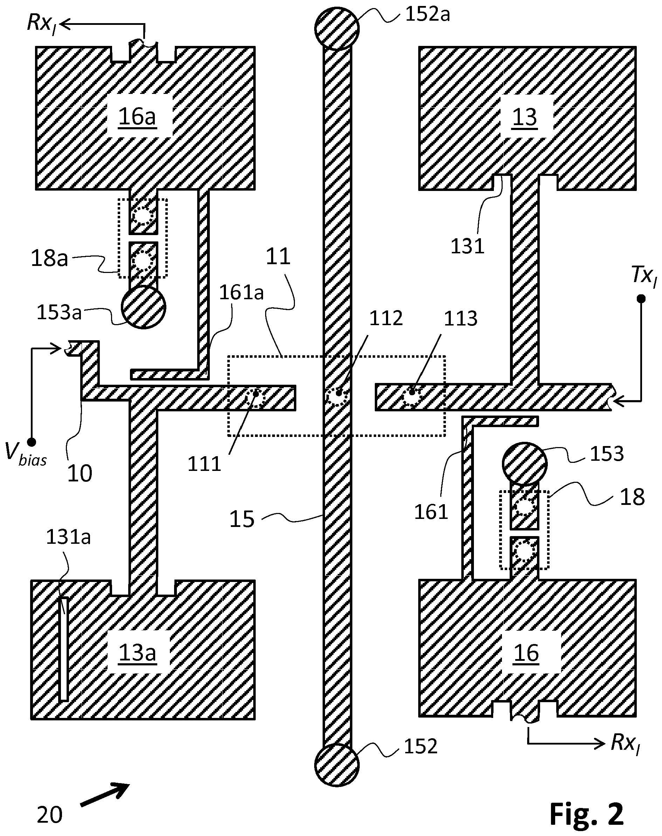

Hierauf basiert der weitere zentrale Vorteil der Erfindung, nämlich, dass die Frequenzwandler-Schaltung 1 auf einer Leiterplattenbasis, die nicht hochfrequenztauglich sein muss, realisiert werden kann. Eine vorteilhafte Ausführungsvariante der in Fig. 1 gezeigten Frequenzwandler-Schaltung 1 auf einer Leiterplatte 20 ist daher in Fig. 2 dargestellt. Hierbei können bezüglich der Leiterbahnen und des Substrates Leiterplattentechnologien nach dem Stand der Technik eingesetzt werden.

Der Transistor 11 bildet bei der Ausführungsvariante, die in Fig. 2 gezeigt ist, das zentrale Element, um den die zwei Sendeantennen 13, 13a bzw. die zwei Empfangsantennen 16, 16a in etwa symmetrisch in einem Viereck angeordnet sind. Hierbei sind die Sendeantennen 13, 13a sowie die Empfangsantennen 16, 16a diagonal gegenüberliegend zueinander angeordnet. Die Antennen 13, 13a, 16, 16a sind als rechteckige Patch-Antennen realisiert, die in der Ebene der Leiterplatte 20 liegen. Der Vorteil einer planaren Ausführung der Antennen 13, 13a, 16, 16a liegt darin, dass sie bei der Fertigung zusammen mit den Leiterbahnen in einem Prozess auf die Leiterplatte 20 aufgebacht werden können. Dementsprechend könnten die Sende- und Empfangsantennen 13, 13a, 16, 16a alternativ auch als Mäander-, Spiral- oder Fraktal-Antennen ausgelegt sein.

Die Form der in Fig. 2 dargestellten Sende- und Empfangsantennen 13, 13a, 16, 16a ist in etwa quadratisch. Die Kantenlänge dieser Patch-Antennen 13, 13a, 16, 16a ist dabei so dimensioniert, dass der Sende-Wirkungsgrad auf die Oberwellenfrequenzen des Transistors 11 bzw. des Schwingkreises 15 optimiert ist, während der Sende-Wirkungsgrad bei der Grundfrequenz des Transistors 11 (welches der Frequenz des niederfrequenten Eingangssignals Txₗ entspricht) minimiert wird.

Die Abstrahl-Richtung der Sendeantennen 13, 13a ist an sich von der Leiterplatte 20 weg ungerichtet. Die Richtwirkung in Richtung des Messobjekts 3, welches in etwa senkrechtem Verlauf zur Oberfläche der Leiterplatte 20 entspricht, wird erst durch die (nicht in Fig. 2 dargestellte) Antennenanordnung 21 bewirkt. Um diese Richtwirkung zu erreichen (und um ohne zusätzliche Verwendung einer Sende-/Empfangsweiche auszukommen), ist es von Vorteil, wenn die Antennenanordnung 21 das hochfrequente Sendesignal Txₕ, das von den zwei Sendeantennen 13, 13a abgestrahlt wird, in eine andere Mode, insbesondere die TE11 Mode, umwandelt. Außerdem ist die Antennenanordnung 21 hierfür so auszugestalten, dass sie das hochfrequente Empfangssignal Rxₕ, welches von dem Messobjekt 3 reflektiert wird, zumindest teilweise in die ursprünglich von der Leiterplatte 20 ausgehende Mode, nämlich die TE22 Mode, zurückwandelt.

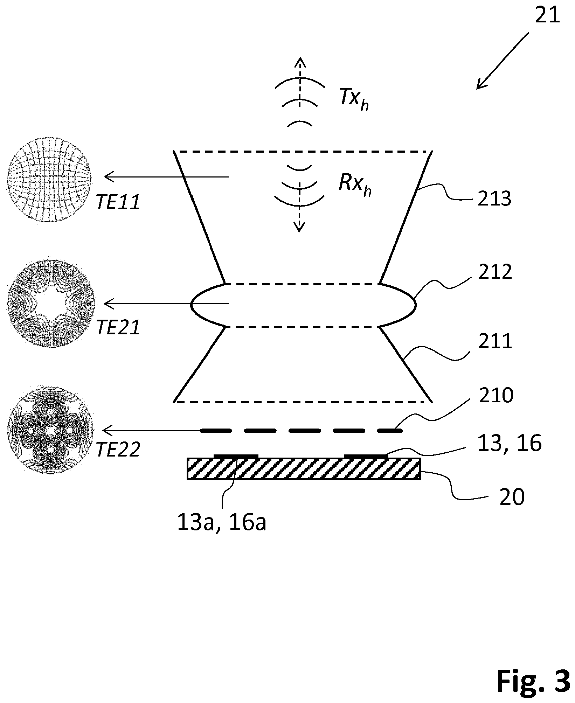

Eine hierfür geeignete Ausgestaltung der Antennenanordnung 21 ist in Fig. 3 dargestellt. Wie dort gezeigt, kann die Antennenanordnung 21 beispielsweise in Form einer modifizierten Hornantenne aufgebaut sein. Die gewünschte Modenwandlung wird in dieser Ausgestaltungsvariante dadurch erreicht, dass die Antennenanordnung 21 in einer Sektion zwischen einem zum Messobjekt 3 gerichteten Horn 213 und einem zu den Sende- und Empfangsantennen 13, 13a, 16, 16a gerichteten Trichter 211 eine Aufweitung 212 aufweist (eine entsprechend dimensionierte Einschnürung wäre ebenfalls möglich). Die Ausrichtung der Antennenanordnung 21 ist in diesem Fall in etwa senkrecht zur Oberfläche der Leiterplatte 20, wobei die Antennenanordnung 21 galvanisch von der Leiterplatte 20 getrennt ist. In dem Trichter 212 findet hierbei jeweils eine Zwischenumwandlung des Sendesignals Txₕ bzw. des Empfangssignals Rxₕ in die TE21 Mode statt.

Die Modenwandlung in der Antennenanordnung 21 wird durch die diagonal gegenüberliegende Anordnung der Sendeantennen 13, 13a bzw. der Empfangsantennen 16, 16a auf der Leiterplatte 20 begünstigt. Hierbei ist es zudem vorteilhaft, wenn zwischen der Antennenanordnung 21 zusätzlich eine galvanisch getrennte planare und metallisch leitende Netzstruktur 210 angebracht ist. Das Netz ist dabei vorzugsweise so auszulegen, dass es sich in vier Segmente aufteilt, wobei jedes Segment die Grundfläche jeweils einer der Patch-Antennen 13, 13a, 16, 16a umrandet.

Diese Ausgestaltungsvariante der Antennenanordnung 21 besitzt zudem die positive Eigenschaft, dass die laterale Positionierung der Antennenanordnung 21 über der Leiterplatte 20 in Bezug zu den Antennen 13, 13a, 16, 16a vergleichsweise unkritisch ist.

Eine weitergehende (nicht dargestellte) Auslegungsvariante der Antennen 13, 13a, 16, 16a, die auf der in Fig. 2 gezeigten Ausgestaltung aufbaut, besteht in der Auslegung jeder einzelnen Antenne aus wiederum einer Zusammensetzung aus jeweils vier quadratisch angeordneten Patch-Teilantennen. Sie haben die vorteilhafte Charakteristik, dass sie etwaige Signalanteile mit Frequenzen weit unterhalb der Frequenz des niederfrequenten Eingangssignals Txₗ stark unterdrücken und somit einen inhärenten Filter gegen solche Störsignale darstellen.

Wie in Fig. 2 dargestellt, weist die zweite Sendeantenne 13a im Gegensatz zu den weiteren Antennen 13, 16, 16a in ihrem Flächen-Inneren zusätzlich eine erste Aussparung 131a auf. Dies führt zu einer künstlichen Verkürzung der Sendeantenne 13a, wodurch sie einen im Vergleich zur ersten Sendantenne 13 verringerten Sende-Wirkungsgrad aufweist. Hierdurch wird der Effekt kompensiert, dass das hochfrequente Sendesignal Txₕ am Gate 111 in der Praxis stärker als an der Source 113 anliegt. Ohne diese Kompensation würde dies zu einer "schielenden" Sende-Charakteristik führen.

Bei dem in Fig. 2 gezeigten Ausführungsbeispiel der erfindungsgemäßen Frequenzwandler-Schaltung 1 sind nicht nur die Antennen 13, 13a, 16, 16a analog zu den Leiterbahnstrukturen auf der Leiterplatte 20 gefertigt. Auch der Schwingkreis 15 ist in Form einer geradlinigen Leiterbahn ausgestaltet, wobei sich der Transistor 11 in Bezug zu den zwei Endbereichen 152, 152 a des Schwingkreises 15 in etwa mittig angeordnet ist. Der leiterbahnartige Schwingkreis 15 ist von der Breite her so ausgelegt, dass er gegenüber der Grundimpedanz des Transistors 11 (in der Praxis zwischen 45 Ohm und 80 Ohm) kapazitiv wirkt. Die Endbereiche 152, 152a der Leiterbahn sind als Durchkontaktierungslöcher 152, 152a zur Signalmasse 19 (welche in der Regel in einer tieferen Lage der Leiterplatte 20 entweder vollflächig oder zumindest als strukturierte Leiterbahnlage ausgestaltet ist). Einerseits tragen die Durchkontaktierungslöcher 152, 152a zumindest einen induktiven Anteil zum Schwingkreis 15 bei. Zum anderen erhöht die Durchkontaktierung zur Signalmasse den kapazitiven Effekt des leiterbahnförmigen Schwingkreises 15.

Die Dioden 18, 18a sind bei der in Fig. 2 gezeigten Ausgestaltungsvariante direkt an der jeweiligen Empfangsantenne 16, 16a angeordnet, um so die Leitungsverluste des hochfrequenten Empfangssignals Rxₕ zu minimieren. Dabei ist es von der Ausgestaltung der Frequenzwandler-Schaltung 1 insgesamt abhängig, ob eine Verschaltung der Dioden 18, 18a in Durchlass- oder Sperrrichtung vorteilhaft ist.

An denjenigen Stellen der Patch Antennen 13, 13a, 16, 16a, an denen sie elektrisch über Leiterbahnen kontaktiert sind, weisen sie im gezeigten Ausführungsbeispiel beidseitig der jeweiligen Leiterbahn eine Ausnehmung 131 auf. Hierdurch können die Patch-Antennen 13, 13a, 16, 16a flächenmäßig insgesamt kompakter ausgelegt werden, ohne dass der Wirkungsgrad verschlechtert wird. Des Weiteren werden sie hierdurch unempfindlicher gegenüber den Störeinflüssen durch die jeweiligen zuführenden Leiterbahnen.

In paralleler Verschaltung zu den Dioden 18, 18a weisen die Empfangsantennen 16, 16a bei der in Fig. 2 gezeigten Ausführungsvariante zwei HF-Kopplungsstrukturen 161, 161a auf, die wiederum in Form von Leiterbahnstrukturen an den Empfangsantennen 16, 16a anschließen: Eine Erste Kopplungsstruktur 161 der ersten Empfangsantenne 16 koppelt hierbei an den Source-Anschluss 113 an. Die zweite Kopplungsstruktur 161a der zweiten Empfangsantenne 16a koppelt an den Gate-Anschluss 111 an.

Die Ausrichtung der Koppelstrukturen 161, 161a verläuft hierbei parallel zu den entsprechenden Leiterbahnen, die zum Gate-Anschluss 111 bzw. dem oder Source-Anschluss 113 führen. Durch die Koppelstrukturen 161, 161a wird jeweils ein niedriger Frequenzanteil in die Empfangsantennen 16, 16a eingekoppelt. Hierdurch wird neben dem Runtermischen des hochfrequenten Empfangssignals Rxₕ gleichzeitig eine Verstärkung des niederfrequenten Auswertesignals Rxₗ ermöglicht. Alternativ zu den Dioden 18, 18a und den Koppelstrukturen 161, 161a könnten diese beiden Funktionen (Runtermischen und Verstärken) auch durch einen entsprechend an der jeweiligen Empfangsantenne 16, 16a verschalteten Verstärker erreicht werden.

Auch eine HF-technische Realisierung des Filters 10 ist auf Basis einer Leiterbahnstruktur möglich. Wie in Fig. 2 dargestellt, ist der Filter 10 als abgewinkelte und verengte Leiterbahnstruktur realisiert, die eine Übertragung hochfrequenter Signale unterbindet.

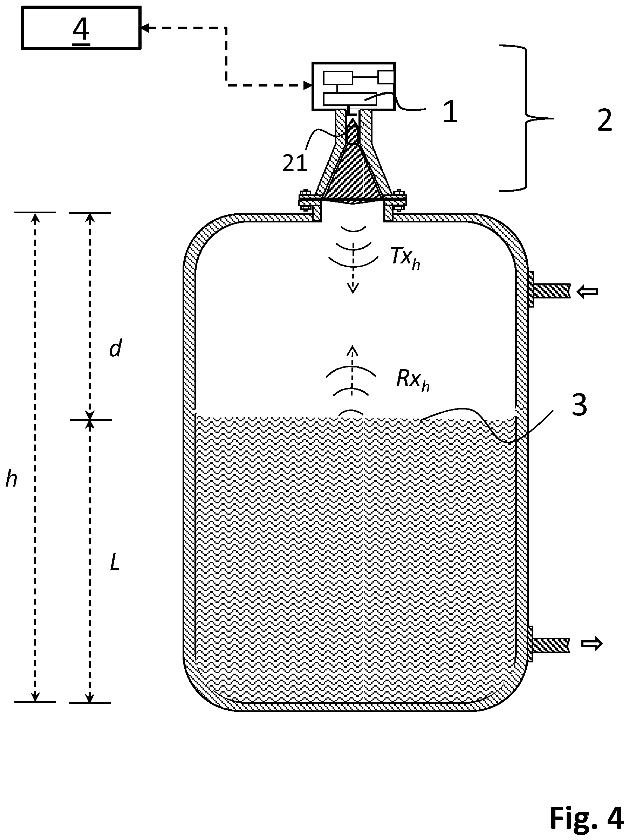

Eine mögliche Applikation der erfindungsgemäßen Frequenzwandler-Schaltung 1 in einem Füllstandsmessgerät 2 ist in Fig. 4 dargestellt: Es zeigt eine typische Anordnung eines nach dem Puls-Laufzeit- oder FMCW-Prinzip arbeitenden Füllstandsmessgerätes 2 an einem Behälter. Im Behälter befindet sich ein Füllgut 3, dessen Füllstand L durch das Füllstandsmessgerät 3 zu bestimmen ist. Hierzu ist das Füllstandsmessgerät 2 in einer vorbekannten Einbauhöhe h oberhalb des Füllgutes 3 am Behälter angebracht. Hierbei kann der Behälter je nach Anwendung bis zu mehr als 30 m hoch sein.

Das Füllstandsmessgerät 2 ist derart am Behälter angeordnet, dass es das hochfrequente Sendesignal Txₕ in Richtung der Oberfläche des Füllgutes 3 aussendet. Nach Reflektion an der Füllgut-Oberfläche wird das hochfrequente Empfangssignal Rxₕ durch die Antenneneinheit 21 der Frequenzwandler-Schaltung 1 empfangen. Hierbei richtet sich die Laufzeit zwischen Aussenden des Sendesignals Txₕ und Empfang des Empfangssignals Rxₕ nach dem Abstand d = h - L zur Füllgut-Oberfläche. Bei Füllstandsmessgeräten nach dem Stand der Technik wird der Füllstand L auf Basis der gemessenen Laufzeit berechnet. Im Falle der Erfindung kann die Laufzeit und somit der Füllstand auf Basis des niederfrequenten Empfangssignals Rxₗ erfolgen, so dass das Füllstandsmessgerät neben der Frequenzwandler-Schaltung 1 keine weiteren Hochfrequenzbaugruppen aufweisen muss.

In der Regel ist das Füllstandsmessgerät 2 über ein Bussystem, etwa "PROFIBUS", "HART" oder "Wireless HART" mit einer übergeordneten Einheit 4, beispielsweise einem Prozessleitsystem, verbunden. Hierhin könnte der ermittelte Füllstand L beispielsweise kommuniziert werden, um etwaige am Behälter vorhandene Zu- und Abflüsse zu steuern.

### Bezugszeichenliste

- 1: Frequenzwandler-Schaltung
- 2: Messgerät
- 3: Messobjekt
- 4: Übergeordnete Einheit
- 10, 10a: Tiefpassfilter
- 11: Nichtlineares Hochfrequenz-Bauteil
- 12: Signaleingang
- 13 ,13a: Sendeantennen
- 14: Spannungsquelle
- 15: Schwingkreis
- 16,16a: Empfangsantennen
- 17: Signalausgang
- 18, 18a: Nichtlineare Halbleiterbauelemente
- 19: Signalmasse
- 20: Leiterplatte
- 21: Antennenanordnung
- 111: Gate-Anschluss
- 112: Drain-Anschluss
- 113: Source-Anschluss
- 131 , 131a: Aussparungen
- 152 , 152a: Durchkontaktierungslöcher
- 153 , 153a: Durchkontaktierungslöcher
- 161 , 161a: Hochfrequenz-Koppelstrukturen
- 210: Netzstruktur
- 211: Trichter
- 212: Aufweitung
- 213: Horn
- d: Abstand
- Rxₕ: Hochfrequentes Empfangssignal
- Rxₗ: Niederfrequentes Auswertesignal
- Txₕ: Hochfrequentes Sendesignal
- Txₗ: Niederfrequentes Eingangssignal
- V_{bias}: Versorgungsspannung

## Patentansprüche

1. Frequenzwandler-Schaltung für ein Radar-basiertes Messgerät (2), welches zur Bestimmung des Abstandes (d) zu einem Messobjekt (3) oder zur Bestimmung von dessen Geschwindigkeit dient, umfassend:
- Einen Bipolar- oder FET-Transistor (11) mit
∘ einem Basis- bzw. Gate-Anschluss (111),
∘ einem als Frequenz-Anschluss (112) dienenden Emitter- bzw. Drain-Anschluss (112), und
∘ einem als Signal-Anschluss (113) dienenden Kollektor- bzw. Source-Anschluss (113), welcher als Signaleingang (12) für ein niederfrequentes Eingangssignal (Txₗ) dient,
- zumindest eine am Signal-Anschluss (113) angeschlossene erste Sendeantenne (13) zur Erzeugung eines hochfrequenten Sendesignals (Txₕ),
- einen Schwingkreis (15), der am Frequenz-Anschluss (112) angeschlossen ist,
- zumindest eine erste Empfangsantenne (16) zum Empfang eines hochfrequenten Empfangssignals (Rxₕ),
- zumindest ein erstes nichtlineares Halbleiterbauelement (18), welches zwischen der ersten Empfangsantenne (16) und einer Signalmasse (19) angeordnet ist,
- eine am Basis- bzw. Gate-Anschluss (111) angeschlossene zweite Sendeantenne (13a) zur Erzeugung des hochfrequenten Sendesignals (Txₕ),
- eine zweite Empfangsantenne (16a) zum Empfang des hochfrequenten Empfangssignals (Rxₕ), wobei die zweite Empfangsantenne (16a) an einem Signalausgang (17) für ein niederfrequentes Auswertesignal (Rxₗ) angeschlossen ist, und
- ein zweites nichtlineares Halbleiterbauelement (18a), welches zwischen der zweiten Empfangsantenne (16a) und der Signalmasse (19) angeordnet ist,
wobei eine Antennenanordnung (21) vorgesehen ist, die das hochfrequente Sendesignal (Txₕ) in Richtung des Messobjektes (3) auskoppelt, und/oder die das vom Messobjekt (3) reflektierte hochfrequente Empfangssignal (Rxₕ) zumindest in die erste Empfangsantenne (16) einkoppelt, und
wobei die erste Empfangsantenne (16) an dem Signalausgang (17) für das niederfrequente Auswertesignal (Rxₗ) angeschlossen ist.

2. Frequenzwandler-Schaltung nach Anspruch 1, wobei am Basis- bzw. Gate-Anschluss (111) eine Spannungsquelle (14) angeschlossen ist.

3. Frequenzwandler-Schaltung nach Anspruch 2, wobei die Spannungsquelle (14) den Basis- bzw. Gate-Anschluss (111) derart mit einer Versorgungsspannung (V_{bias}) versorgt, dass der Transistor (11) im Sättigungsbereich arbeitet.

4. Frequenzwandler-Schaltung nach zumindest einem der vorhergehenden Ansprüche, wobei der Schwingkreis (15) auf die Frequenz am Signaleingang (12) abgestimmt ist.

5. Frequenzwandler-Schaltung nach einem der Ansprüche 1 bis 4, wobei der Transistor (11) als Hochfrequenz-Transistor ausgelegt ist.

6. Frequenzwandler-Schaltung nach zumindest einem der vorhergehenden Ansprüche, wobei die Frequenzwandler-Schaltung (1) auf einer Leiterplatte (20) angeordnet ist.

7. Frequenzwandler-Schaltung nach Anspruch 6, wobei zumindest die erste Sendeantenne (13, 13a) und/oder zumindest die erste Empfangsantenne (16, 16a) als Patch-Antennen/Antenne ausgelegt sind/ist.

8. Frequenzwandler-Schaltung nach Anspruch 7, wobei die zweite Sendeantenne (13a) derart ausgestaltet ist, dass sie einen im Vergleich zur ersten Sendeantenne (13) verschiedenen Sende-Wirkungsgrad aufweist.

9. Frequenzwandler-Schaltung nach einem der Ansprüche 6 bis 8, wobei der Schwingkreis (15) als Leiterbahn ausgestaltet ist.

10. Frequenzwandler-Schaltung (1) nach Anspruch 9, wobei der als Leiterbahn ausgestaltete Schwingkreis (15) geradlinig verläuft und zumindest in einem Endbereich mit einem Durchkontaktierungsloch (152) verbunden ist.

11. Frequenzwandler-Schaltung nach zumindest einem der vorhergehenden Ansprüche, wobei die Antennenanordnung (21) derart ausgestaltet ist, dass sie das hochfrequente Sendesignal (Txₕ), welches von der ersten Sendeantenne (13) und der zweiten Sendeantenne (13a) ausgestrahlt wird, in eine TE11 Mode der Antennenanordnung (21) umwandelt, und/oder wobei die Antennenanordnung (21) derart ausgestaltet ist, dass sie das hochfrequente Empfangssignal (Rxₕ), welches von dem Messobjekt (3) reflektiert wird, in eine TE22 Mode der Antennenanordnung (21) umwandelt.

12. Frequenzwandler-Schaltung nach zumindest einem der Ansprüche 6 bis 11, wobei die erste Empfangsantenne (16) eine als Leiterbahn ausgestaltete erste Hochfrequenz-Koppelstruktur (161), die an den Source-Anschluss (113) ankoppelt, aufweist, und/oder wobei die zweite Empfangsantenne (16a) eine als Leiterbahn ausgestaltete zweite Hochfrequenz-Koppelstruktur (161a), die an den Basis- bzw. Gate-Anschluss (111) ankoppelt, aufweist.

13. Frequenzwandler-Schaltung nach zumindest einem der vorhergehenden Ansprüche, wobei es sich bei dem nichtlinearen Halbleiterbauelement (18, 18a) um eine Diode, insbesondere eine Hochfrequenz-Diode handelt.

14. Radar-basiertes Füllstandsmessgerät, umfassend: eine Frequenzwandler-Schaltung nach zumindest einem der vorhergehenden Ansprüche.

## Claims

1. Frequency converter circuit for a radar-based measuring device (2), said device being used to determine the distance (d) in relation to a measurement object (3) or to determine its velocity, said circuit comprising:
- a bipolar or FET transistor (11) with
∘ a base or gate connection (111),
∘ an emitter or drain connection (112) serving as a frequency connection (112), and
∘ a collector or source connection (113) serving as a signal connection (113), said connection serving as a signal input (12) for a low-frequency input signal (Txi),
- at least a first emission antenna (13) connected to the signal connection (113), said antenna being designed to generate a high-frequency emitting signal (Txₕ),
- an oscillating circuit (15), which is connected to the frequency connection (112),
- at least a first reception antenna (16) to receive a high-frequency reception signal (Rxₕ),
- at least a first non-linear semi-conductor component (18), which is arranged between the first reception antenna (16) and a signal ground (19),
- a second emission antenna (13a) connected to the base or gate connection (111), wherein said antenna is designed to generate the high-frequency emitting signal (Txₕ),
- a second reception antenna (16a) designed to receive the high-frequency reception signal (Rxₕ), the second reception antenna (16a) being connected to a signal output (17) for a low-frequency evaluation signal (Rxₗ), and
- a second non-linear semi-conductor component (18a) arranged between the second reception antenna (16a) and the signal ground (19),
wherein an antenna arrangement (21) is provided, which decouples the high-frequency emitting signal (Txₕ) in the direction of the measurement object (3) and/or which couples the high-frequency reception signal (Rxₕ) reflected by the measurement object (3) at least into the first reception antenna (16), and wherein the first reception antenna (16) is connected to the signal output (17) for the low-frequency evaluation signal (Rxₗ).

2. Frequency converter circuit as claimed in Claim 1, wherein a voltage source (14) is connected to the base or gate connection.

3. Frequency converter circuit as claimed in Claim 2, wherein the voltage source (14) supplies the base or gate connection (111) with a supply voltage (V_{bias}) in such a way that the transistor (11) operates in the saturation zone.

4. Frequency converter circuit as claimed in at least one of the previous claims, wherein the oscillating circuit (15) is matched to the frequency at the signal input (12).

5. Frequency converter circuit as claimed in one of the Claims 1 to 4, wherein the transistor (11) is designed as a high-frequency transistor.

6. Frequency converter circuit as claimed in at least one of the previous claims, wherein the frequency converter circuit (1) is arranged on a printed circuit board (20).

7. Frequency converter circuit as claimed in Claim 6, wherein at least the first emission antenna (13, 13a) and/or at least the first reception antenna (16, 16a) is/are designed as patch antenna(s).

8. Frequency converter circuit as claimed in Claim 7, wherein the second emission antenna (13a) is designed to have a transmission efficiency that is different compared to that of the first emission antenna (13).

9. Frequency converter circuit as claimed in one of the Claims 6 to 8, wherein the oscillating circuit (15) is designed as a conducting path.

10. Frequency converter circuit as claimed in Claim 9, wherein the oscillating circuit (15) designed as a conducting path extends straight and is connected to a via (152) at least in an end area.

11. Frequency converter circuit as claimed in at least one of the previous claims, wherein the antenna arrangement (21) is designed to convert the high-frequency emitting signal (Txₕ) - which is emitted by the first emission antenna (13) and the second emission antenna (13a) - to a TE11 mode of the antenna arrangement (21), and/or
wherein the antenna arrangement (21) is designed to convert the high-frequency reception signal (Rxₕ) - which is reflected by the measurement object (3) - to a TE22 mode of the antenna arrangement (21).

12. Frequency converter circuit as claimed in at least one of the Claims 6 to 11, wherein the first reception antenna (16) comprises a first high-frequency coupling structure (161) in the form of a conducting path, wherein said first structure is coupled to the source connection (113), and/or
wherein the second reception antenna (16a) comprises a second high-frequency coupling structure (161a) in the form of a conducting path, wherein said second structure is coupled to the base or gate connection (111).

13. Frequency converter circuit as claimed in at least one of the previous claims, wherein the non-linear semi-conductor component (18, 18a) is a diode, particularly a high-frequency diode.

14. Radar-based level transmitter, comprising: a frequency converter circuit as claimed in at least one of the previous claims.

## Revendications

1. Circuit de convertisseur de fréquence destiné à un appareil de mesure (2) basé sur un radar, lequel appareil sert à la détermination de la distance (d) par rapport à un objet de mesure (3) ou à la détermination de sa vitesse, lequel circuit comprend :
- un transistor bipolaire ou FET (11) avec
∘ une connexion de base ou de grille (111),
∘ une connexion d'émetteur ou de drain (112) servant de connexion de fréquence (112), et
∘ une connexion de collecteur ou de source (113) servant de connexion de signal (113), laquelle connexion sert d'entrée de signal (12) pour un signal d'entrée (Txₗ) basse fréquence,
- au moins une première antenne d'émission (13) raccordée à la connexion de signal (113), laquelle antenne est destinée à générer un signal d'émission haute fréquence (Txₕ),
- un circuit oscillant (15), lequel est relié à la connexion de fréquence (112),
- au moins une première antenne de réception (16) destinée à recevoir un signal de réception haute fréquence (Rxₕ),
- au moins un premier composant semi-conducteur non linéaire (18), lequel est disposé entre la première antenne de réception (16) et une masse de signal (19),
- une deuxième antenne d'émission (13a) raccordée à la connexion de base ou de grille (111), laquelle antenne est destinée à générer le signal d'émission haute fréquence (Txₕ),
- une deuxième antenne de réception (16a) destinée à recevoir le signal de réception haute fréquence (Rxₕ), la deuxième antenne de réception (16a) étant raccordée à une sortie de signal (17) pour un signal d'exploitation basse fréquence (Rxₗ), et
- un deuxième composant semi-conducteur non linéaire (18a) disposé entre la deuxième antenne de réception (16a) et la masse du signal (19),
circuit pour lequel il est prévu un arrangement d'antennes (21), qui découple le signal d'émission haute fréquence (Txₕ) en direction de l'objet de mesure (3) et/ou qui injecte le signal de réception haute fréquence (Rxₕ) réfléchi par l'objet de mesure (3) au moins dans la première antenne de réception (16), et
la première antenne de réception (16) étant raccordée à la sortie de signal (17) pour le signal d'exploitation basse fréquence (Rxₗ).

2. Circuit de convertisseur de fréquence selon la revendication 1, pour lequel une source de tension (14) est raccordée à la connexion de base ou de grille.

3. Circuit de convertisseur de fréquence selon la revendication 2, pour lequel la source de tension (14) alimente la connexion de base ou de grille (111) avec une tension d'alimentation (V_{bias}) telle que le transistor (11) fonctionne dans la zone de saturation.

4. Circuit de convertisseur de fréquence selon au moins l'une des revendications précédentes, pour lequel le circuit oscillant (15) est accordé sur la fréquence à l'entrée du signal (12).

5. Circuit de convertisseur de fréquence selon l'une des revendications 1 à 4, pour lequel le transistor (11) est conçu en tant que transistor haute fréquence.

6. Circuit de convertisseur de fréquence selon au moins l'une des revendications précédentes, pour lequel le circuit de convertisseur de fréquence (1) est disposé sur une carte de circuit imprimé (20).

7. Circuit de convertisseur de fréquence selon la revendication 6, pour lequel au moins la première antenne d'émission (13, 13a) et/ou au moins la première antenne de réception (16, 16a) est/sont conçue(s) en tant qu'antenne / antenne patch.

8. Circuit de convertisseur de fréquence selon la revendication 7, pour lequel la deuxième antenne d'émission (13a) est conçue pour avoir une efficacité d'émission différente comparée à celle de la première antenne d'émission (13).

9. Circuit de convertisseur de fréquence selon l'une des revendications 6 à 8, pour lequel le circuit oscillant (15) est conçu en tant que piste conductrice.

10. Circuit de convertisseur de fréquence selon la revendication 9, pour lequel le circuit oscillant (15) conçu en tant que piste conductrice s'étend en ligne droite et est relié au moins dans une zone d'extrémité avec un trou traversant (152).

11. Circuit de convertisseur de fréquence selon au moins l'une des revendications précédentes, pour lequel l'arrangement d'antennes (21) est conçu pour convertir le signal d'émission haute fréquence (Txₕ) - qui est émis par la première antenne d'émission (13) et la deuxième antenne d'émission (13a) - en un mode TE11 de l'arrangement d'antennes (21), et/ou
pour lequel l'arrangement d'antennes (21) est configuré pour convertir le signal de réception haute fréquence (Rxₕ) - qui est réfléchi par l'objet de mesure (3) - en un mode TE22 de l'arrangement d'antennes (21).

12. Circuit de convertisseur de fréquence selon au moins l'une des revendications 6 à 11, pour lequel la première antenne de réception (16) comprend une première structure de couplage haute fréquence (161) sous la forme d'une piste conductrice, laquelle première structure est couplée à la connexion de source (113), et/ou
pour lequel la deuxième antenne de réception (16a) comprend une deuxième structure de couplage haute fréquence (161a), laquelle deuxième structure est couplée à la connexion de base ou de grille (111).

13. Circuit de convertisseur de fréquence selon au moins l'une des revendications précédentes, pour lequel le composant semi-conducteur non linéaire (18, 18a) est une diode, notamment une diode haute fréquence.

14. Transmetteur de niveau basé sur un radar, comprenant : un circuit de convertisseur de fréquence selon au moins l'une des revendications précédentes.
